Europäisches Patentamt

European Patent Office

Office européen des brevets

(19)

(11) Veröffentlichungsnummer: **0 249 119**
**A1**

(12) **EUROPÄISCHE PATENTANMELDUNG**

(21) Anmeldenummer: 87107894.5

(51) Int. Cl.4: **H03K 19/21**

(22) Anmeldetag: 01.06.87

(30) Priorität: 10.06.86 DE 3619449

(43) Veröffentlichungstag der Anmeldung:
16.12.87 Patentblatt 87/51

(84) Benannte Vertragsstaaten:
**AT DE FR GB NL**

(71) Anmelder: **Siemens Aktiengesellschaft Berlin und München**
**Wittelsbacherplatz 2**
**D-8000 München 2(DE)**

(72) Erfinder: **Köppe, Siegmar, Dipl.-Ing.**
**Am Kamp 18**
**D-3014 Laatzen(DE)**

(54) **Aufwandsreduzierte Antivalenz-und Äquivalenz-Gatterschaltung zur Verwendung in aktiven Testhilfen für Schaltungsanordnungen in CMOS-Technik.**

(57) Eine aufwandsreduzierte Antivalenz-Gatterschaltung zur Verwendung in einer aktiven Testhilfe für Schaltungsanordnungen in CMOS-Technik, bei der ein erster Signaleingang (1), dem ein erstes Eingangssignal (A) zuzuführen ist, mit dem Gate-Anschluß eines n-Kanal-Transfertransistors (31) und mit dem Gate-Anschluß eines p-Kanal-Transfertransistors (33) verbunden ist, ein zweiter Signaleingang (2), dem ein zweites Eingangssignal (B) zuzuführen ist, mit dem Source-Anschluß des p-Kanal-Transfertransistors (33) und ein dritter Signaleingang (O), dem das invertierte zweite Eingangssignal ($\bar{B}$) zuzuführen ist, mit dem Source-Anschluß des n-Kanal-Transfertransistors (31) verbunden ist und bei der der Drain-Anschluß des n-Kanal-Transfertransistors (31) und der Drain-Anschluß des p-Kanal-Transfertransistors (33) gemeinsam mit einem Signalausgang (3), über den ein Ausgangssignal (C) abzuführen ist, verbunden sind. Die erforderlichen komplementen Eingangssignale stehen in der umgebenden Schaltung der aktiven Testhilfe zur Verfügung.

FIG 4

EP 0 249 119 A1

## Aufwandsreduzierte Antivalenz-und Äquivalenz-Gatterschaltungen zur Verwendung in aktiven Testhilfen für Schaltungsanordnungen in CMOS-Technik

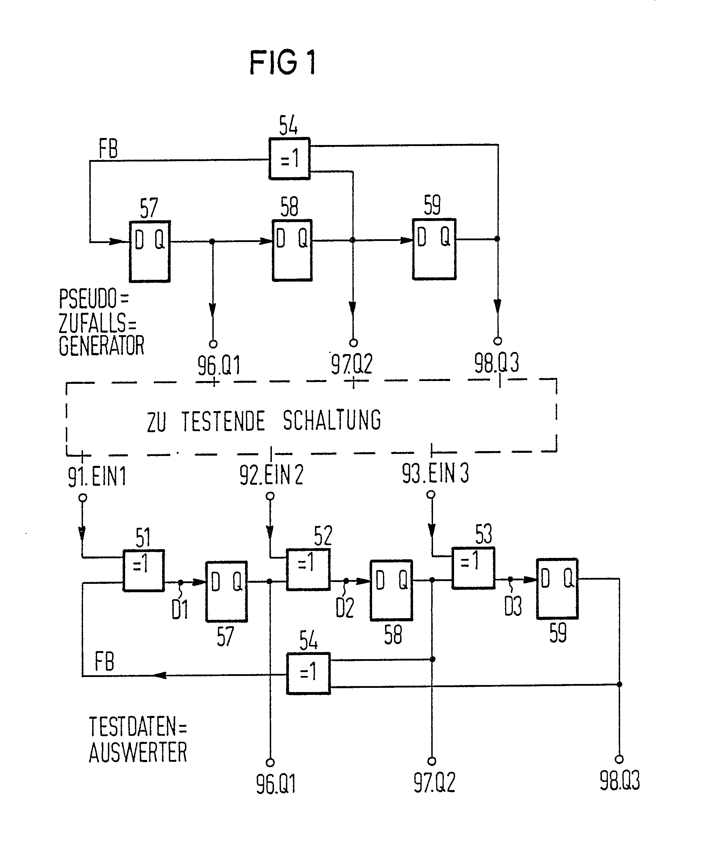

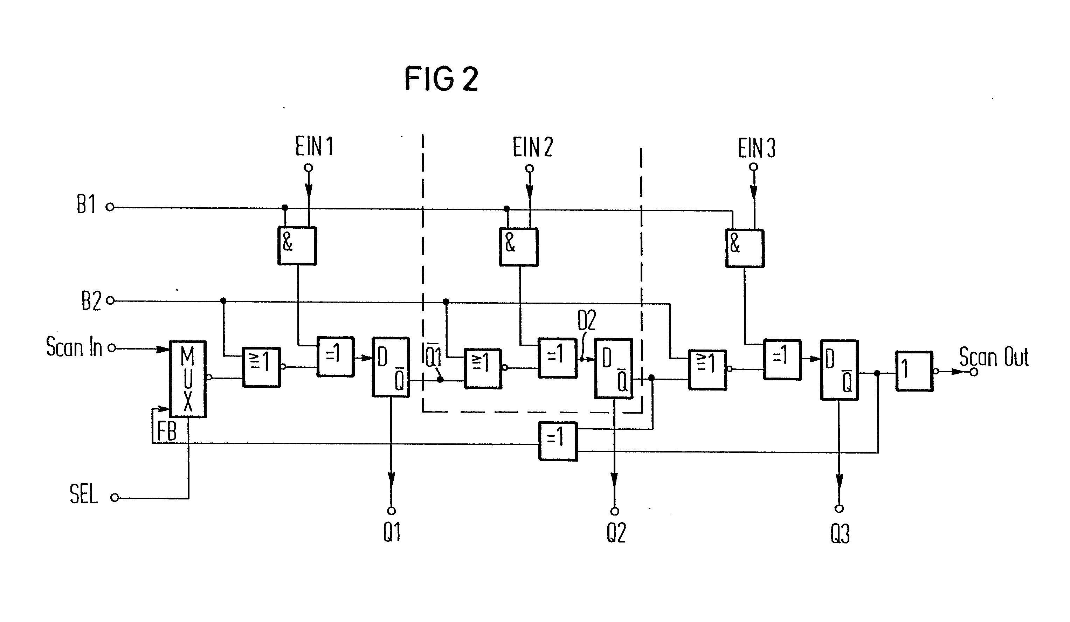

Aktive Testhilfen sind Voraussetzung für einen Selbsttest von digitalen Schaltungen. Durch linear rückgekoppelte Schieberegister lassen sich pseudozufällige Testmusterfolgen erzeugen, während eine Auswertung der Testantworten in einem Signaturregister Testdatenauswerter unter gleichzeitiger Reduktion der Datenmenge erfolgen kann, vergl. Fig. 1. Eine erweiterte Struktur, die die Funktionskonvertierung eines normalen Registers in Testmustergenerator (TMG) oder Testdatenauswerter (TDA) ermöglicht, vergl. Fig. 2, ist unter der Bezeichnung "BILBO"-Register, vergl. B. Könemann, J. Mucha, G. Zwiehoff, "Built-In Logic Block Observation Techniques", IEEE Test Conference, Oct. 1979, pp. 37-41.

Alle genannten Strukturen enthalten, wie Fig. 1 und Fig. 2 zeigen, Antivalenz-Gatterschaltungen (EXOR-Gatter). Sie dienen entweder zum Einspeisen der Eingangssignale, wie beim Signaturregister und beim BILBO-Register, oder zur Realisierung der linearen Rückkopplung.

Bei der hardwaremäßigen Realisierung sind diese EXOR-Gatter bezüglich des Platzbedarfes besonders kritisch, da sie - gerade bei sog. Bit-Slice-Architekturen - wesentlich das Layout-Raster beeinflussen und damit zu einer deutlichen Aufweitung der genannten Registerstrukturen führen. (Anmerkung: Anstelle der EXOR-Gatter können ggf. auch EXNOR-Gatter (Äquivalenz-Gatterschaltungen) verwendet werden.)

Durch eine besonders einfache Realisierung sowohl der Antivalenz-als auch der Äquivalenzfunktion könnte dieses Problem beseitigt werden.

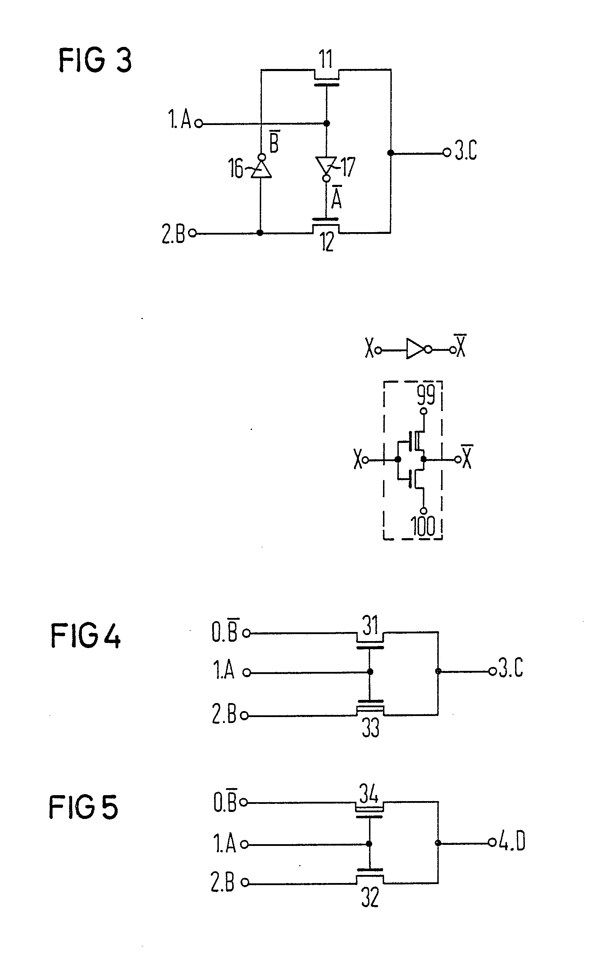

Schaltungen zur Realisierung der Antivalenz-bzw. der Äquivalenzfunktion in Feldeffekttransistor-Technik sind bekannt. Sie sind im allgemeinen aus Schaltungen zur Realisierung der beiden logischen Grundfunktionen NAND und NOR (und deren Mischformen ANDNOR und ORNAND) zusammengesetzt. Die Anzahl der erforderlichen Transistoren ist entsprechend hoch. In Fig. 3 ist beispielhaft eine mögliche Realisierung der Antivalenzfunktion (EXOR) in statischer CMOS-Technik dargestellt. Hierzu sind zehn Transistoren erforderlich.

Der vorliegenden Erfindung liegt die Aufgabe zugrunde, Antivalenz-und Äquivalenz-Gatterschaltungen zu schaffen, die eine gegenüber dem Stand der Technik wesentlich verringerte Anzahl von Transistoren benötigen.

Zur Lösung dieser Aufgabe werden verschiedene Antivalenz-bzw. Äquivalenz-Gatterschaltungen zur Verwendung in aktiven Testhilfen gemäß den Oberbegriffen mehrerer voneinander unabhängiger Patentansprüche vorgeschlagen, welche Gatterschaltungen jeweils durch die in den kennzeichnenden Teilen dieser Patentansprüche angegebenen Merkmale charakterisiert sind.

Vorteilhafte Weiterbildungen der vorliegenden Erfindung sind durch die Merkmale der Unteransprüche gekennzeichnet.

Im folgenden wird die Erfindung anhand mehrerer Figuren im einzelnen erläutert.

Fig. 1 zeigt eine bekannte Anordnung mit einem als Testmustergenerator fungierenden linear rückgekoppelten Schieberegister, einer zu testenden Schaltung und einem Testdatenauswerter, wobei das Schieberegister und der Testdatenauswerter Antivalenz-(EXOR) -Gatterschaltungen enthalten, die gemäß der vorliegenden Erfindung realisiert werden können.

Fig. 2 zeigt eine Ausführungsform einer bekannten BILBO-Registeranordnung für 3 bit Breite, die ebenfalls Antivalenz-(EXOR) -Gatterschaltungen enthält, die gemäß der vorliegenden Erfindung realisiert werden können.

Fig. 3 zeigt ein Ausführungsbeispiel für eine Antivalenz-Gatterschaltung im CMOS-Technik gemäß einer bekannten Gatterschaltungskonzeption.

Fig. 4 zeigt eine erste erfindungsgemäße Ausführungsform einer Antivalenz-Gatterschaltung.

Fig. 5 zeigt eine erste erfindungsgemäße Ausführungsform einer Äquivalenz-Gatterschaltung.

Fig. 6 zeigt einen Ausschnitt einer möglichen Realisierung eines "parallelen" Signaturregisters als - schaltungstechnische Umgebung eines Antivalenzgatters.

Fig. 7 zeigt einen Ausschnitt einer möglichen Realisierung eines "parallelen" Signaturregisters analog zu der Anordnung gemäß Fig. 6, wobei das Antivalenzgatter entsprechend der vorliegenden Erfindung ausgebildet ist.

Fig. 8 zeigt eine kaskadenförmige Antivalenz-Gatterschaltung gemäß der vorliegenden Erfindung.

Fig. 9 zeigt eine gegenüber der in Fig. 8 gezeigten Anordnung weitergebildete Anordnung.

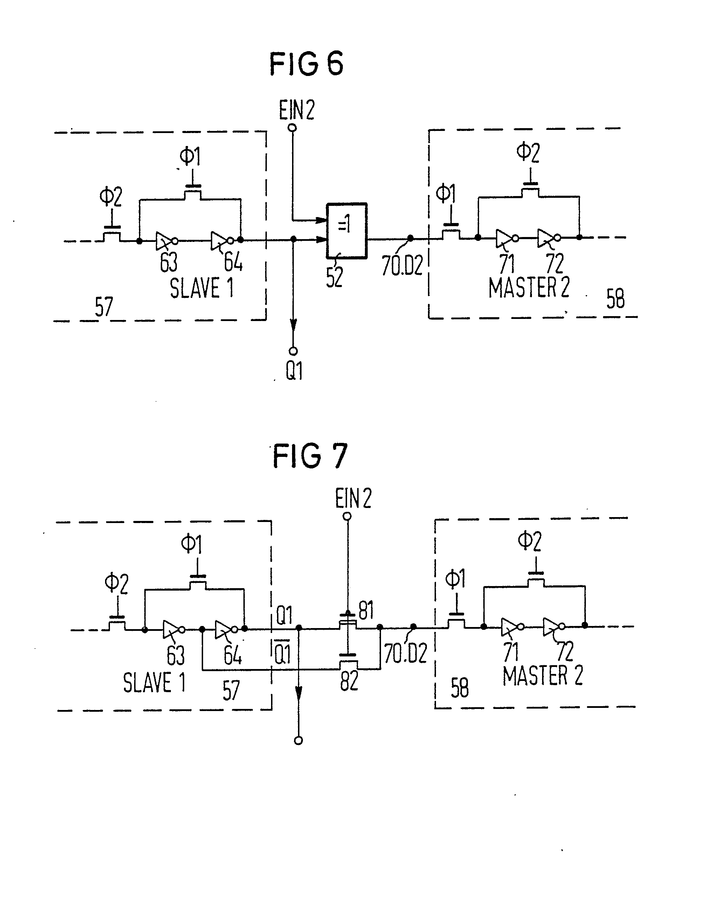

Funktionsbedingt müssen alle Registerzellen in den aktiven Testhilfen als Master-Slave-Flip-Flops ausgelegt werden. Die Erfindung geht von der Erkenntnis aus, daß bei derartigen Registerzellen das Ausgangssignal sowohl in invertierter als auch in nichtinvertierter Form ($Q_i$ und $\overline{Q}_i$) zur Verfügung steht. Daher können sämtliche EXOR-(EXNOR-) Gatter in den aktiven Testhilfen durch nur zwei Transistoren je Funktion realisiert werden, vergl. Fig. 4 und Fig. 5.

Fig. 4 zeigt eine erfindungsgemäße aufwandsreduzierte Antivalenz-Gatterschaltung, bei der ein erster Signaleingang 1, dem ein erstes Eingangssignal A zuzuführen ist, mit dem Gate-Anschluß eines n-Kanal-Transfertransistors 31 und mit dem Gate-Anschluß eines p-Kanal-Transfertransistors 33 verbunden ist, ein zweiter Signaleingang 2, dem ein zweites Eingangssignal B zuzuführen ist, mit dem Source-Anschluß des p-Kanal-Transfertransistors 33 und ein dritter Signaleingang O, dem das invertiert zweite Eingangssignal $\overline{B}$ zuzuführen ist, mit dem Source-Anschluß des n-Kanal-Transfertransistors 3 verbunden ist und bei der der Drain-Anschluß des n-Kanal-Transfertransistors 31 und der Drain-Anschluß des p-Kanal-Transfertransistors 33 gemeinsam mit einem Signalausgang 3, über den ein Ausgangssignal C abzuführen ist, verbunden sind.

Fig. 5 zeigt eine erfindungsgemäße aufwandsreduzierte Äquivalenz-Gatterschaltung, bei der ein erster Signaleingang 1, dem ein erstes Eingangssignal A zuzuführen ist, mit dem Gate-Anschluß eines n-Kanal-Transfertransistors 32 und mit dem Gate-Anschluß eines p-Kanal-Transfertransistors 34 verbunden ist, ein zweiter Signaleingang 2, dem ein zweites Eingangssignal B zuzuführen ist, mit dem Source-Anschluß des n-Kanal-Transfertransistors 32 und ein dritter Signaleingang (O), dem das invertierte zweite Eingangssignal $\overline{B}$ zuzuführen ist, mit dem Source-Anschluß des p-Kanal-Transfertransistors 34 verbunden ist und bei der der Drain-Anschluß des n-Kanal-Transfertransistors 32 und der Drain-Anschluß des p-Kanal-Transfertransistors 34 gemeinsam mit einem Signalausgang 4, über den ein Ausgangssignal D abzuführen ist, verbunden sind.

Da die Strukturen eines Testmustergenerators, vergl. Fig. 1, in denen eines Signaturregisters, vergl. Fig. 2, enthalten sind, wird im folgenden der Einsatz der erfindungsgemäßen Gatterschaltung in einem parallelen Signaturregister, das als der Testdatenauswerter fungiert, erläutert. Dabei sind zwischen den Registerzellen angeordnete EXOR-Gatter 51 bis 53 zum Einspeisen von Eingangssignalen EIN1 bis EIN3 bezüglich des Platzbedarfs besonders kritisch, da sie wesentlich das Layout-Raster beeinflussen. Hier bietet die erfindungsgemäße Schaltungsanordnung den angestrebten Vorteil.

Zur Verdeutlichung der Zusammenhänge ist die Umgebung des EXOR-Gatters oder der Antivalenz-Gatterschaltung 52 aus Fig. 1 als detaillierter Ausschnitt einer möglichen Realisierung in Fig. 6 dargestellt. Dabei wird willkürlich angenommen, daß die Registerzellen 57 bis 59 als statische Master-Slave-Flip-Flops ausgebildet sind, welche durch nichtüberlappenden Takte 01 und 02 gesteuert werden. (Anmerkung: Die Art der Registerzellen hat keinen Einfluß auf die erfindungsgemäße Realisierung; es genügt, daß Registerzellen Inverter enthalten.)

Wie Fig. 7 zeigt, sind die Source-Anschlüsse zweier Transfertransistoren 81, 82 einer Antivalenz-Gatterschaltung mit dem Signalausgang $Q_1$ einer Registerzelle 57 bzw. dem invertierten Signalausgang $\overline{Q}_1$ derselben verbunden.

Die Eingangssignale des EXOR-Gatters 52 sind mit EIN2 und Q1 bezeichnet. Das Signal Q1 wird durch einen Inver ter 64 erzeugt. An dessen Eingang liegt demnach $\overline{Q1}$ an (Ausgang eines Inverters 63). Das EXOR-Gatter 52 kann also, wie in Fig. 7 dargestellt, durch zwei Transistoren realisiert werden, wobei das Signal EIN2 (ein Eingang des parallelen Signaturregisters) die Steuerung der als Multiplexer fungierenden Anordnung übernimmt.

Für EIN2 = O wird das Signal Q1 (Ausgang des Inverters 64) über den p-Kanal-Transfertransistor 81 an D2 (Eingang der Registerzelle 58 der zweiten Stufe des Signaturregisters) durchgeschaltet, Transistor 82 ist gesperrt. Für EIN2 = 1 leitet der n-Kanal-Transfertransistor 82 (Transistor 81 sperrt), und an D2 liegt das Signal $\overline{Q1}$ (Ausgang des Inverters 63) an. Da die beiden Signale Q1 und $\overline{Q1}$ nahe beieinander verfügbar sind, ist der Platzbedarf für die Zufüh-rung des invertierten Signals $\overline{Q1}$ zum EXOR-Gatter vernachlässigbar.

Als Verzögerung ergibt sich für die Antivalenzfunktion eine Transfertransistor-Laufzeit. Die nachfolgende Stufe - im Beispiel das Master-Flip-Flop der Registerzelle 58 - bewirkt eine Auffrischung des Signalpegels.

Die EXOR-Gatter im Rückkopplungszweig lassen sich ebenfalls mit minimalem Aufwand von nur 2 Transistoren je Funktion realisieren. Dies sei ebenfalls beispielhaft anhand des parallelen Signaturregisters gemäß Fig. 1 erläutert.

Das Signal D1 am Eingang der Registerzelle 57 der ersten Stufe des Signaturregisters wird durch das EXOR-Gatter 51 erzeugt und ergibt sich als Antivalenz des Eingangssignals EIN1 und des Rückkopplungssignals FB, welches von Gatter 54 wiederum als Antivalenz der Signale Q2 und Q3 gebildet wird:

$$D1 = EIN1 \oplus Q2 \oplus Q3$$

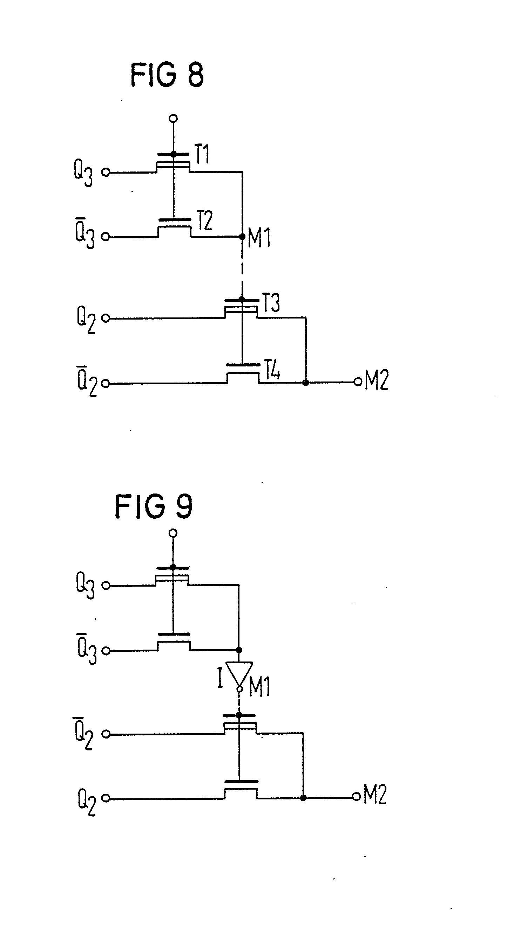

Eine derartige Kaskade zur Verknüpfung von drei Signalen läßt sich mit nur vier Transistoren realisieren, vergl. Fig. 8.

In Fig. 8 ist eine erfindungsgemäße Gatterschaltung für n Eingangsvariablen zur Verwendung in einer aktiven Testhilfe für Schaltungsanordnungen in CMOS-Technik gezeigt, bei der vorgesehen ist, daß n-1 Transfertransistorpaare $T_1$ /$T_2$, $T_3$ /$T_4$ vorgesehen sind, wobei die Transfertransistorpaare jeweils einen p-Kanal-Transfertransistor $T_1$, $T_3$ und einen n-Kanal-Transfertransistor $T_2$, $T_4$ enthalten, daß ein erster Signaleingang, dem ein erstes Eingangssignal EIN1 als die erste Eingangsvariable der n Eingangsvariablen zuzuführen ist mit den Gate-Anschlüssen der Transfertransistoren eines ersten Transfertransistorpaares $T_1$ /$T_2$ verbunden ist, daß die Source-Anschlüsse der Transfertransistoren des ersten Transfertransistorpaares $T_1$/$T_2$ mit einem zweiten Signaleingang $Q_3$ bzw. einem diesem zugeordneten Hilfseingang $\overline{Q_3}$ verbunden sind, denen ein zweites Eingangssignal als zweite Eingangsvariable der n Eingangsvariablen bzw. das invertierte zweite Eingangssignal zuzuführen ist, daß die Source-Anschlüsse der Transfertransistoren eines zweiten Transfertransistorpaares mit einem dritten Signaleingang bzw. einem diesem zugeordneten Hilfseingang verbunden sind, denen ein drittes Eingangssignal als dritte Eingangsvariable der n Eingangsvariablen bzw. das invertierte dritte Eingangssignal zuzuführen ist, usw., daß die Source-Anschlüsse der Transfertransistoren eines (n-1)-ten Transfertransistorpaares $T_3$/$T_4$ mit einem n-ten Signaleingang $Q_2$ bzw. einem diesem zugeordneten Hilfseingang $\overline{Q_2}$ verbunden sind, denen ein n-tes Eingangsignal als n-te Eingangsvariable bzw. das invertierte n-te Eingangssignal zuzuführen ist, daß die Drain-Anschlüsse der Transfertransistoren der n-2 Transfertransistorpaare jeweils einen Signalausgang $M_1$ bilden, der mit den Gate-Anschlüssen der Transfertransistoren des jeweils nachgeordneten Transfertransistorpaares verbunden ist, und daß der Signalausgang $M_2$ des (n-1)-ten Transfertransistorpaares den Signalausgang der Gatterschaltung bildet.

Im vorliegenden Anwendungsfall ist n = 3.

Zur Erzeugung des Signals D1 (vergl. Fig. 1) ist zunächst das Eingangssignal EIN1 mit Q2 oder Q3 zu verknüpfen (es sei willkürlich Q3 gewählt), wobei das Signal EIN1 die Steuerung des Multiplexers übernimmt. Der Ausgang dieses Multiplexers (Signal M1 = EIN1 $\oplus$ Q3) steuert wiederum den zweiten Multiplexer, an dessen Eingängen Q2 und $\overline{Q2}$ anliegen:

$$M2 = M1 \oplus Q2 = EIN1 \oplus Q3 \oplus Q2$$

Das Ausgangssignal M2 des zweiten Multiplexers in der Kaskade ist somit identisch mit dem gewünschten Signal D1, da die Reihenfolge der Verknüpfung bei der Antivalenz-und der Äquivalenzfunktion beliebig ist (assoziative Funktionen).

Im BILBO-Register (siehe Fig. 2) finden sich die Stukturen eines Signaturregisters wieder. Über die Belegung der beiden Eingänge B1 und B2 wird die Betriebsart eingestellt:

| B1 | B2 | Betriebsart |
|---|---|---|
| 0 | 0 | Schieberegister (Prüfbus) oder Pseudo-zufallszahlengenerator (TMG) (je nach Stellung des Multiplexers MUX) |
| 0 | 1 | Rücksetzungen des Registers (RESET) |
| 1 | 0 | Paralleles Signaturregister (TDA) |
| 1 | 1 | Normalbetrieb als Register |

Wie ersichtlich, ist bei der erfindungsgemäßen kaskadenartigen Gatterschaltung möglich, daß die Zuordnung des p-Kanal-und des n-Kanal-Transfertransistors zu dem betreffenden Signaleingang bzw. dem diesem zugeordneten Hilfseingang jeweils derart ist, daß die Gatterschaltung eine Antivalenzgatterfunktion erfüllt. Ebenso ist es möglich, daß die Zuordnung des p-Kanal-und des n-Kanal-Transfertransistors zu dem betreffenden Signaleingang bzw. dem diesem zugeordneten Hilfseingang jeweils derart ist, daß die Gatterschaltung eine Äquivalenzgatterfunktion erfüllt.

Je nach Anwendungsfall kann es vorteilhaft sein, die kaskadenartige Gatterschaltung derart auszubilden, daß jeweils zwischen den Drain-Anschlüssen der Transistoren eines Transfertransistorpaares und dem jeweils zugeordneten Signalausgang $M_1$ ein Inverter eingefügt ist, der zur Signalauffrischung dient.

Zusammenfassend ist festzustellen, daß erfindungsgemäß eine aktive Testhilfe für Schaltungsanordnungen in CMOS-Technik mit aufwandsreduzierten Antivalenz-Gatterschaltungen geschaffen werden kann, die derart ausgeführt ist, daß ein linear rückgekoppeltes 3-Bit-Schieberegister als Pseudozufallsgenerator vorgesehen ist; bei dem ein erster Signaleingang einer Antivalenz-Gatterschaltung 54 mit einem Signalausgang Q einer von drei Registerzellen 58 des Schieberegisters verbunden ist, bei dem ein zweiter Signaleingang der Antivalenz-Gatterschaltung 54 mit einem Signalausgang Q einer der Registerzelle 58 nachgeordneten Registerzelle 59 verbunden ist und bei dem der Signalausgang der Antivalenz-Gatterschaltung 54 mit einem Signaleingang D einer der Registerzelle 59 nachgeordneten weiteren Registerzelle 57 verbunden ist, wobei die drei Registerzellen 57, 58, 59 zusammen mit der Antivalenz-Gatterschaltung 54 ein in an sich bekannter Weise gebildetes rückgekoppeltes Schieberegister bilden, dessen drei Signalausgänge über Klemmen $96, Q_1$ bis $98, Q_3$ mit betreffenden Eingängen einer zu testenden Schaltungsanordnung verbunden sind, und daß ein als Testdatenauswerter fungierendes paralleles 3-Bit-Signaturregister vorgesehen ist, dessen drei Registerzellen 51, 52, 53 in entsprechender Weise wie bei dem als Pseudozufallsregister fungierenden Schieberegister 54, 57, 58, 59 mittels einer Antivalenz-Gatterschaltung 54 zu einem in an sich bekannter Weise rückgekoppelten Schieberegister zusammengeschaltet sind, wobei jeweils zwischen zwei aufeinanderfolgend angeordneten Registerzellen 57/58, 58/59, 59/51 weitere Antivalenz-Gatterschaltungen 51, 52, 53 in an sich bekannter Weise eingefügt sind, deren jeweils erste Signaleingänge jeweils mit betreffenden Signalausgängen der zu testenden Schaltung verbunden sind, wobei die Antivalenz-Gatterschaltung 54 mit ihrem Signalausgang nicht unmittelbar mit dem Signaleingang der betreffenden Registerzelle 58, sondern mittelbar über den zweiten Signaleingang der dieser Registerzelle 57 vorgeordneten Antivalenz-Gatterschaltung 51 und durch diese hindurch verbunden ist und wobei die Signalausgänge der Registerzellen 57, 58, 59 über Klemmen $96, Q_1$ bis $98, Q_3$ aus der Anordnung herausgeführt sind.

## Ansprüche

1. Aufwandsreduzierte Antivalenz-Gatterschaltung zur Verwendung in einer aktiven Testhilfe für Schaltungsanordnungen in CMOS-Technik, dadurch **gekennzeichnet,**
-daß ein erster Signaleingang (1), dem ein erstes Eingangssignal (A) zuzuführen ist, mit dem Gate-Anschluß eines n-Kanal-Transfertransistors (31) und mit dem Gate-Anschluß eines p-Kanal-Transfertransistors (33) verbunden ist, ein zweiter Signaleingang (2), dem ein zweites Eingangssignal (B) zuzuführen ist, mit dem Source-Anschluß des p-Kanal-Transfertransistors (33) und ein dritter Signaleingang (O), dem das invertierte zweite Eingangssignal ( $\overline{B}$ ) zuzuführen ist, mit dem Source-Anschluß des n-Kanal-Transfertransistors (31) verbunden ist und
-daß der Drain-Anschluß des n-Kanal-Transfertransistors (31) und der Drain-Anschluß des p-Kanal-Transfertransistors (33) gemeinsam mit einem Signalausgang (3), über den ein Ausgangssignal (C) abzuführen ist, verbunden sind.

2. Aufwandsreduzierte Äquivalenz-Gatterschaltung zur Verwendung in einer aktiven Testhilfe für Schaltungsanordnungen in CMOS-Technik, dadurch **gekennzeichnet,**
-daß ein erster Signaleingang (1), dem ein erstes Eingangssignal (A) zuzuführen ist, mit dem Gate-Anschluß eines n-Kanal-Transfertransistors (32) und mit dem Gate-Anschluß eines p-Kanal-Transfertransistors (34) verbunden ist, ein zweiter Signaleingang (2), dem ein zweites Eingangssignal (B) zuzuführen ist, mit dem Source-Anschluß des n-Kanal-Transfertransistors (32) und ein dritter Signaleingang (O), dem das invertierte zweite Eingangssignal ( $\overline{B}$ ) zuzuführen ist, mit dem Source-Anschluß des p-Kanal-Transfertransistors (34) verbunden ist und

-daß der Drain-Anschluß des n-Kanal-Transfertransistors (32) und der Drain-Anschluß des p-Kanal-Transfertransistors (34) gemeinsam mit einem Signalausgang (4), über den ein Ausgangssignal (D) abzuführen ist, verbunden sind.

3. Kaskadenartige Gatterschaltung für n Eingangsvariablen zur Verwendung in einer aktiven Testhilfe für Schaltungsanordnungen in CMOS-Technik, dadurch **gekennzeichnet,**

-daß n-1 Transfertransistorpaare ($T_1/T_2$, $T_3/T_4$; $T_1/T_2$, $T_5/T_6$) vorgesehen sind, wobei die Transfertransistorpaare jeweils einen p-Kanal-Transfertransistor ($T_1$, $T_3$; $T_1$, $T_5$) und einen n-Kanal-Transfertransistor ($T_2$, $T_4$; $T_2$, $T_6$) enthalten,

-daß ein erster Signaleingang (U), dem ein erstes Eingangssignal als die erste Eingangsvariable der n Eingangsvariablen zuzuführen ist, mit den Gate-Anschlüssen der Transfertransistoren eines ersten Transfertransistorpaares ($T_1/T_2$) verbunden ist,

-daß die Source-Anschlüsse der Transfertransistoren des ersten Transfertransistorpaares ($T_1/T_2$) mit einem zweiten Signaleingang (V) bzw. einem diesem zugeordneten Hilfseingang ($\overline{V}$) verbunden sind, denen ein zweites Eingangssignal als zweite Eingangsvariable der n Eingangsvariablen bzw. das invertierte zweite Eingangssignal zuzuführen ist,

-daß die Source-Anschlüsse der Transfertransistoren eines zweiten Transfertransistorpaares mit einem dritten Signaleingang bzw. einem diesem zugeordneten Hilfseingang verbunden sind, denen ein drittes Eingangssignal als dritte Eingangsvariable der n Eingangsvariablen bzw. das invertierte dritte Eingangssignal zuzuführen ist, usw.,

-daß die Source-Anschlüsse der Transfertransistoren eines (n-1)-ten Transfertransistorpaares mit einem n-ten Signaleingang (W) bzw. einem diesem zugeordneten Hilfseingang ($\overline{W}$) verbunden sind, denen ein n-tes Eingangssignal als n-te Eingangsvariable bzw. das invertierte n-te Eingangssignal zuzuführen ist,

-daß die Drain-Anschlüsse der Transfertransistoren der n-2 Transfertransistorpaare jeweils einen Signalausgang ($M_1$) bilden, der mit den Gate-Anschlüssen der Transfertransistoren des jeweils nachgeordneten Transfertransistorpaares ($T_3/T_4$; $T_5/T_6$) verbunden ist, und

-daß der Signalausgang ($M_2$) des (n-1)-ten Transfertransistorpaares den Signalausgang der Gatterschaltung bildet.

4. Kaskadenartige Gatterschaltung nach Anspruch 3, dadurch **gekennzeichnet,** daß n = 3 ist.

5. Kaskadenartige Gatterschaltung nach Anspruch 3 oder 8, dadurch **gekennzeichnet,** daß die Zuordnung des p-Kanal-und des n-Kanal-Transfertransistors zu dem betreffenden Signaleingang bzw. dem diesem zugeordneten Hilfseingang jeweils derart ist, daß die Gatterschaltung eine Antivalenzgatterfunktion erfüllt.

6. Kaskadenartige Gatterschaltung nach Anspruch 3 oder 8, dadurch **gekennzeichnet,** daß die Zuordnung des p-Kanal-und des n-Kanal-Transfertransistors zu dem betreffenden Signaleingang bzw. dem diesem zugeordneten Hilfseingang jeweils derart ist, daß die Gatterschaltung eine Äquivalenzgatterfunktion erfüllt.

7. Kaskadenartige Gatterschaltung nach einem der Ansprüche 3 - 6, dadurch **gekennzeichnet,** daß jeweils zwischen den Drain-Anschlüssen der Transistoren eines Transfertransistorpaares und dem jeweils zugeordneten Signalausgang ($M_1$) ein Inverter eingefügt ist.

8. Aktive Testhilfe für Schaltungsanordnungen in CMOS-Technik, mit aufwandsreduzierten Antivalenz-Gatterschaltungen nach Anspruch 4, dadurch **gekennzeichnet,**

-daß ein linear rückgekoppeltes 3-Bit-Schieberegister als Pseudozufallsgenerator vorgesehen ist, bei dem ein erster Signaleingang einer Antivalenz-Gatterschaltung (54) mit einem Signalausgang (Q) einer von drei Registerzellen (58) des Schieberegisters verbunden ist, bei dem ein zweiter Signaleingang der Antivalenz-Gatterschaltung (54) mit einem Signalausgang (Q) einer der Registerzelle (58) nachgeordneten Registerzelle (59) verbunden ist und bei dem der Signalausgang der Antivalenz-Gatterschaltung (54) mit einem Signaleingang (D) einer der Registerzelle (59) nachgeordneten weiteren Registerzelle (57) verbunden ist, wobei die drei Registerzellen (57, 58, 59) zusammen mit der Antivalenz-Gatterschaltung (54) ein in an sich bekannter Weise gebildetes rückgekoppeltes Schieberegister bilden, dessen drei Signalausgänge über Klemmen (96,$Q_1$ bis 98,$Q_3$) mit betreffenden Eingängen einer zu testenden Schaltungsanordnung verbunden sind, und

-daß ein als Testdatenauswerter fungierendes paralleles 3-Bit-Signaturregister vorgesehen ist, dessen drei Registerzellen (51, 52, 53) in entsprechender Weise wie bei dem als Pseudozufallsregister fungierenden Schieberegister (54, 57, 58, 59) mittels einer Antivalenz-Gatterschaltung (54) zu einem in an sich bekannter Weise rückgekoppelten Schieberegister zusammengeschaltet sind, wobei jeweils zwischen zwei aufeinanderfolgend angeordneten Registerzellen (57/58, 58/59, 59/51) weitere Antivalenz-Gatterschaltungen (51, 52, 53) in an sich bekannter Weise eingefügt sind, deren jeweils ersten Signaleingänge jeweils mit betreffenden Signalausgängen der zu testenden Schaltung verbunden sind, wobei die Antivalenz-Gatterschaltung (54) mit ihrem Signalausgang nicht unmittelbar mit dem Signaleingang der betreffenden Registerzelle (58), sondern mittelbar über den zweiten Signaleingang der dieser Registerzelle (57) vorgeordneten Antivalenz-Gatterschaltung (51) und durch diese hindurch verbunden ist und wobei die Signalausgänge der Registerzellen (57, 58, 59) über Klemmen (96,$Q_1$ bis 98,$Q_3$) aus der Anordnung herausgeführt sind.

9. Schaltungsanordnung mit einer aufwandsreduzierten Antivalenz-Gatterschaltung nach Anspruch 4, vorzugsweise zur Verwendung in einer aktiven Testhilfe für Schaltungsanordnungen in CMOS-Technik dadurch **gekennzeichnet,** daß die Source-Anschlüsse der beiden Transfertransistoren (81, 82) der Antivalenz-Gatterschaltung mit dem Signalausgang ($Q_1$) einer Registerzelle (57) bzw. dem invertierten Signalausgang ($\overline{Q}_1$) derselben verbunden sind.

# FIG 1

PSEUDO=
ZUFALLS=
GENERATOR

ZU TESTENDE SCHALTUNG

TESTDATEN=
AUSWERTER

FIG 2

**FIG 3**

**FIG 4**

**FIG 5**

# FIG 6

EIN 2

Φ1

Φ2                    Φ1

63        64
=1
SLAVE 1
52        70.D2

71        72
MASTER 2
57                                                    58

Q1

# FIG 7

EIN 2

Φ1

Φ2                    81        Φ1        Φ2

63        64        Q1        70.D2        71        72
Q1
SLAVE 1        57        82        58        MASTER 2

FIG 8

FIG 9

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | IBM TECHNICAL DISCLOSURE BULLETIN, Band 25, Nr. 5, Oktober 1982, Seiten 2375-2376, New York, US; Z.T. DEARDEN et al.: "Four-device exclusive or CMOS circuit" * Figuren; Seiten 2375-2376 * | 1 | H 03 K 19/21 |
| | --- | | |
| Y | Idem | 2-6 | |
| | --- | | |
| Y | PROCEEDINGS OF THE IEEE, Band 73, Nr. 4, April 1985, Seiten 592-598, IEEE, New York, US; P. PIRSCH: "Design of a DPCM codec for VLSI realization in CMOS technology" * Figur 6; Seite 593, rechte Spalte, Zeilen 5-8 * | 2,6 | |
| | | | **RECHERCHIERTE SACHGEBIETE (Int. Cl.4)** |
| | --- | | |
| A | Idem | 7 | H 03 K |
| | --- | | |
| Y | FR-A-2 296 969 (COMPAGNIE IBM FRANCE) * Figur 1; Seite 2, Zeilen 24-26 * | 3-6 | |
| | --- | | |
| A | US-A-4 601 034 (SRIDHAR) * Figuren 3,4; Spalte 5, Zeile 62 - Spalte 9, Zeile 3 * & JP-A-61 003 400 (09-01-1986) | 1,8,9 | |
| | ---     -/- | | |

Der vorliegende Recherchenbericht wurde für alle Patentansprüche erstellt.

| Recherchenort DEN HAAG | Abschlußdatum der Recherche 04-09-1987 | Prüfer FEUER F.S. |
|---|---|---|

## EINSCHLÄGIGE DOKUMENTE

Seite 2

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | IEEE TEST CONFERENCE, 11.-13. November 1980, Seiten 15-21, IEEE, New York, US; E.J. McCLUSKEY et al.: "Design for autonomous test"<br>* Figuren 6,7; Seite 18, rechte Spalte, Zeile 1 - Seite 19, rechte Spalte, Zeile 11 *<br><br>--- | 8,9 | |
| A | IEEE SOUTHEASTCON, CONFERENCE PROCEEDINGS, 31. März - 3. April 1985, Seiten 366-370, IEEE, New York, US; D.S. CHO et al.: "On the three-level PLA for logic minimization"<br>* Figur 5; Seite 368, linke Spalte, Zeilen 17-21 *<br><br>----- | 1-4 | |

RECHERCHIERTE SACHGEBIETE (Int. Cl.4)

Der vorliegende Recherchenbericht wurde für alle Patentansprüche erstellt.

| Recherchenort | Abschlußdatum der Recherche | Prüfer |
|---|---|---|
| DEN HAAG | 04-09-1987 | FEUER F.S. |